# EUROPEAN PATENT SPECIFICATION

(11) **EP 0 267 447 B1**
(45) Date of publication and mention of the grant of the patent: **24.03.1993**
(21) Application number: 87114899.5
(22) Date of filing: 13.10.1987
(51) Int. Cl.: H01L 29/78, H01L 29/72, H01L 29/10, H01L 27/06, H02H 5/04

(54) **A vertical DMOS power transistor with an integral operating condition sensor**
Senkrechter Leistungstransistor des DMOS-Typs mit Integriertem Operationszustandsensor
Transistor DMOS vertical de puissance ayant un senseur des conditions de service intégré

(30) Priority: 12.11.1986 US 929961
(43) Date of publication of application: 18.05.1988
(73) Proprietor: SILICONIX Incorporated, Santa Clara California 95054 (US)
(72) Inventor: Blanchard, Richard A., Los Altos California 94022 (US); Cooper, David, Saratoga California 95070 (US)
(74) Representative: Meddle, Alan Leonard

(56) References cited:
- EP-A- 0 097 866
- DE-A- 2 351 732
- FR-A- 2 530 079
- PATENT ABSTRACTS OF JAPAN vol. 5, no 19 (E-44)(691), 4 February 1981; & JP-A- 55 146954

## Description

This invention relates to semiconductor devices and more specifically to a vertical double diffused metal oxide semiconductor (DMOS) power switching transistor device with an operating condition sensor.

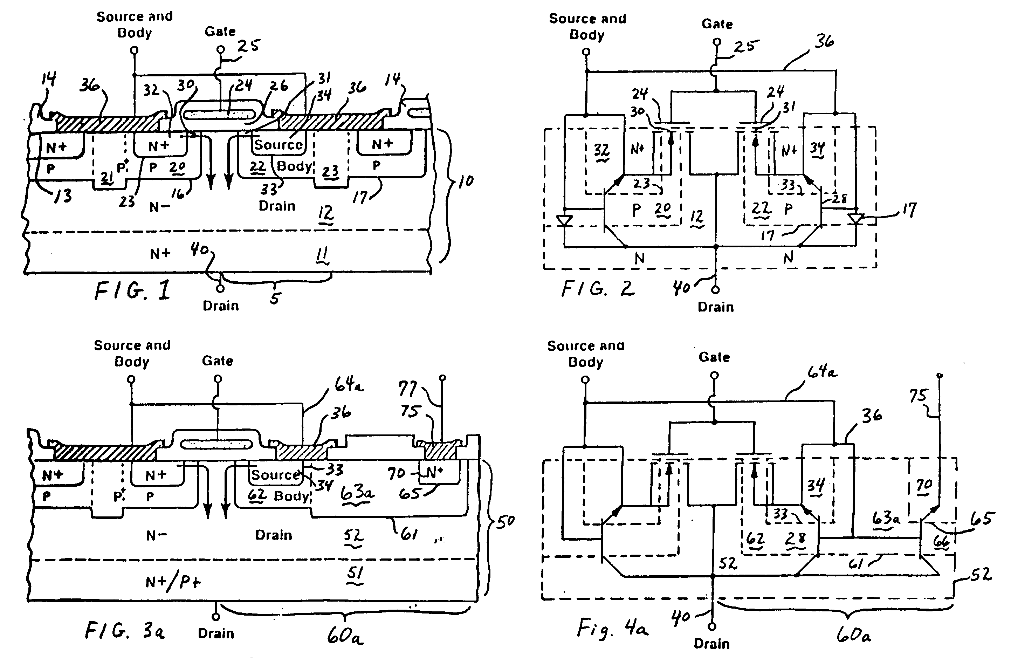

Prior art vertical DMOS transistor devices, as described for example in U.S. Patents No. 4,430,792 and 4,443,931 (which corresponds to EP-A-0 097 866) and reproduced in Figure 1, are field effect transistor (FET) cell structures in which a common substrate drain 10 serves multiple vertical DMOS cells. In DMOS cell 5 on the right side of drain lead 40 and of gate lead 25 in Figure 1, substrate drain 10 is formed from N+ wafer 11 with N- epitaxial layer 12, which sustains a high breakdown voltage. Beneath substrate surface 13, P type body diffusion 22 contains smaller, N+ type source diffusion 34. On surface 13 over drain 12 and adjacent body diffusion 22, gate dielectric 26 supports polycrystalline silicon gate 24. In N-channel DMOS cell 5, a positive bias applied to gate 24 establishes channel 31 across the top of body 22 for electron flow from source 34 to drain 12.

In a typical power switching DMOS device as shown in Figure 1, a symmetrical pair of DMOS cells on the right and left share common gate electrode 24, which enables current to flow simultaneously from sources 32 and 34 through respective channels 30 and 31 to common drain 12. Body regions 22 and 23 may be portions of a continuous N+ source diffusion meeting outside the plane of Figure 1. For multiple-ampere power switching, the source region 20 or 22 perimeter typically extends many centimeters in a series of cells or interdigitated fingers resembling in cross-section the structure of Figure 1.

So that N+ source 34, P- body 22, and N- substrate 12 will not operate as an intrinsic NPN transistor 28, Figure 2, junctions 23 and 33 are typically shorted on surface 13 by common source/body contact(s) 36 to the adjacent P- body regions 21 and 23. Increased conductivity deep body regions 21 and 23 also forestall junctions 23 and 33 from becoming forward biased.

Rapid switching with a large substrate drain make DMOS devices well suited for high current density power switching applications, but high power switching dissipates large amounts of heat, which if not controlled can potentially destroy DMOS power switching devices. Therefore these devices need to be protected from overheating in some applications. Prior art DMOS devices have been protected from overheating by for example heat sink casings and/or external current limiting circuits. A thermal sensor can be positioned nearby and used in a feedback loop to control current, and thus temperature, in a DMOS device. However, these prior art methods may not indicate temperature precisely in channel 22 and upper drain 12, or the amperage flowing through cell 5, Figure 1. Large area devices such as high current DMOS transistors or other MOS gated devices can have sharp temperature gradients, making it important to sample temperatures near high current density regions.

One DMOS cell temperature measuring technique uses one of the cell's PN junctions for a test current, which is a function of junction bias and temperature. Such a junction test current is a more direct and accurate measurement of temperature than a normal operating cell channel current measurement, which also depends upon source-to-gate bias. To measure the operating cell 5 current between leads 36 and 40 across junction 17, independently of a channel 31 current, gate 24 must be grounded and the lead 36-to-lead 40 bias must be reversed, interrupting normal operation of cell 5. In many applications, continuous operation and/or external circuit requirements prohibit interrupting DMOS transistor operation for such measurements.

A prior art technique reported in Electronic Design, June 28, 1984, pp. 50-52, monitors operating DMOS device condition with a current mirror circuit, not shown. Current through a first transistor (e.g. the left side of Figure 2) is mirrored by proportional current through a second (mirror) transistor (e.g. the right side of Figure 2). The mirrored current can be measured through a resistor, not shown, in series with lead 36, to indicate temperature without interrupting operation of the first transistor.

It is also known to provide diodes on a substrate for temperature sensing, as seen in German Application 2351732 and Japanese Application 54-54644; however, these diodes require a significant amount of silicon surface area and may be too distant from the device being measured to accurately measure the temperature of the device.

There remains, therefore, a need for a DMOSFET power switching device in which temperature can be measured directly, accurately, and without interfering with device operation.

Accordingly, the present invention provides a vertical DMOS cell structure having the features of claim 1.

The present invention provides a DMOS power switching cell structure with an integral temperature sensor for accurately measuring temperature in the immediate vicinity of high density current, without interfering with normal power switching operation of the cell.

While avoiding interference with operation, the invention makes an accurate temperature measurement by measuring a test current through, or a test voltage across a PN junction, provided by at least one new region of conductivity type opposite to the surrounding region of the cell, with a new electrical contact to the at least one region, and optionally a second electrical contact to the second region surrounding the first region.

A first embodiment provides a DMOS cell with a new diode well in an extended deep body region, and provides an electrical contact to the new diode well.

In the Accompanying Drawings :-
Figure 1 is a cross section of a prior art vertical DMOS transistor including two cells;
Figure 2 is a schematic of the structure of Figure 1;
Figure 3a is a cross section of a vertical DMOS transistor device having an integral temperature sensing diode according to the present invention;

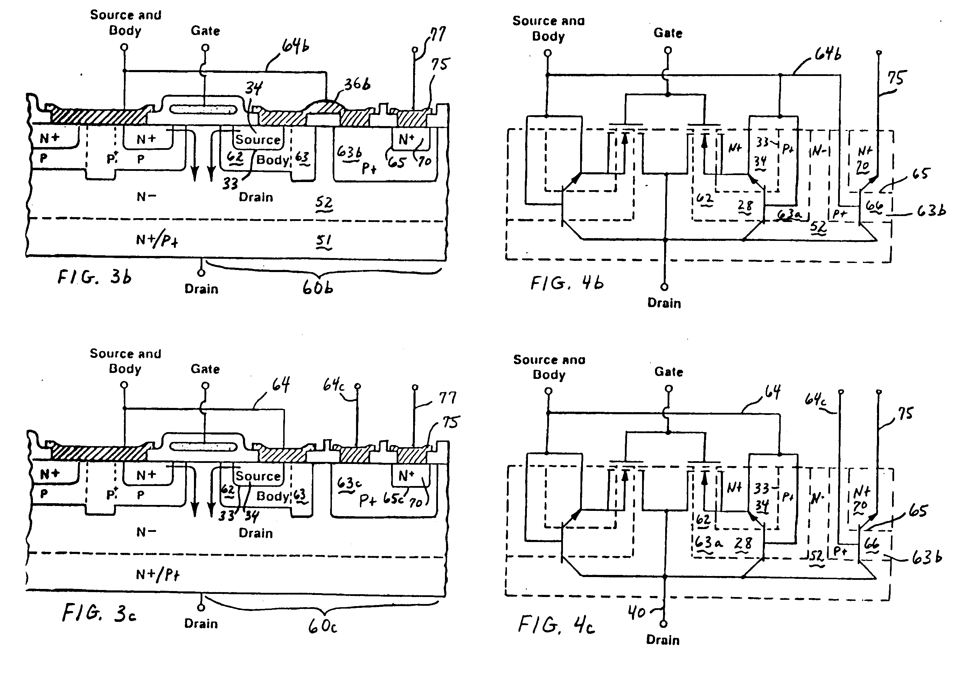

Figs. 3 b,c,d are further examples of DMOS transistor devices with an integrated sensor diode

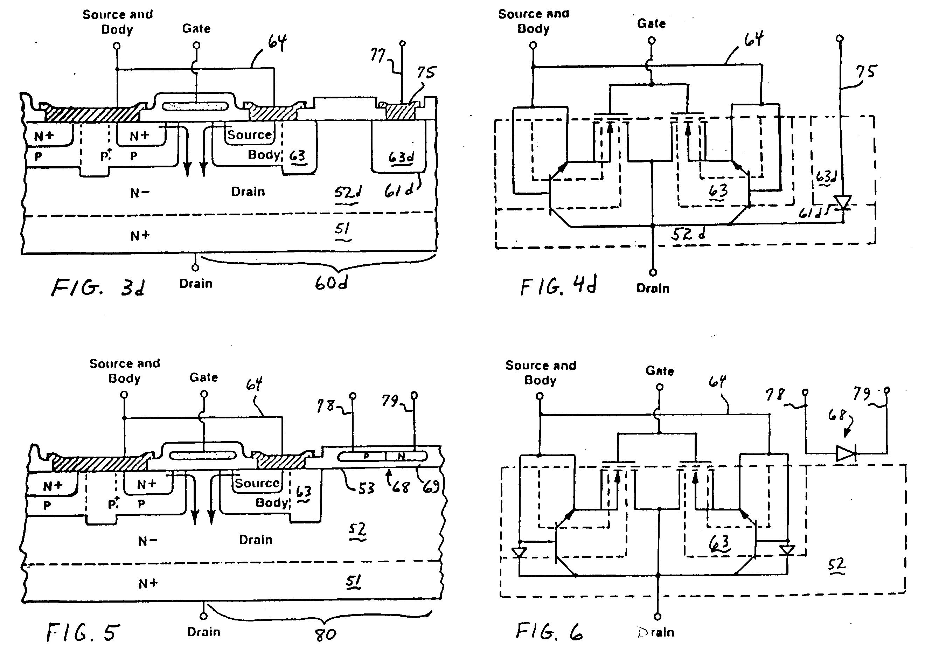

Figures 4a, 4b, 4c, and 4d are schematics of the respective Figure 3 structures;
Figure 5 is a cross section of another example which forms a temperature sensing diode from single crystal or polycrystalline silicon which is electrically isolated from the DMOS device; and
Figure 6 is a schematic of the structure of Figure 5.

The present invention provides a vertical DMOS power switching cell with an integral operating condition sensor, as cell 60a in cross-section Figure 3a. Further examples are shown as cells 60b, 60c, 60d and 80 in Figs. 3b, 3c, 3d and 5 Equivalent circuits are shown in schematic Figures 4a, 4b, 4c, 4d, and 6, respectively, with some regions corresponding to regions of Figure 1 DMOS cell 5 described above. Unlike prior art cell 5 with deep body region 23, this invention in Figure 3a cell 60a modifies deep body region 63a to have a greater lateral dimension, and to include additional and oppositely predoped or implanted well region 70. Well 70 serves as the cathode of diode 65 formed by the PN junction with body 63, which serves as the anode. In other embodiments, not shown, conductivity types of all regions are reversed to provide a body region cathode and a well region anode.

As explained with reference to Figures 1 and 2 prior art DMOS cell 5, in Figure 3a cell 60a, drain region 52, body region 62, and source region 34 form intrinsic NPN transistor 28, Figure 4a. Similarly, well 70 added to body region 63a and substrate 52 forms intrinsic NPN transistor 66, Figure 4a. When lead 75 does not forward bias transistor 66 base-emitter junction 65, transistor 66 is off and does not interfere with the normal switching operation of cell 60a. However, when lead 75 is biased negatively with respect to channel/body lead 64a, to cause a test current across junction 65, then during normal operation of cell 60a, positively biased region 52 can provide a collector current to turn on transistor 66, adding lead 40 current to the lead 64a current measured across junction 65 and out lead 75. To minimize this addition of current from lead 40, the intrinsic NPN transistor 66 current gain should be sufficiently low so that the collector 52 to emitter 70 with base 63a open breakdown voltage (BVceo) is not significantly lower, and encountered earlier, than its collector 52 to base 63a with emitter 70 breakdown voltage with the emitter shorted to the base (BVces). One way of obtaining low gain is to control doping so that base region 63a has a relatively high P-type dopant concentration compared to adjacent emitter junction 65 to obtain a low emitter injection efficiency, and to control doping so that base region 63a has a high net P-type dopant concentration per unit surface area of the base between base-emitter junction 65 and base-collector junction 61 to obtain a low base transport factor.

In the examples of Figure 3b and 3c, cells 60b and 60c have sensor anode body regions 63b and 63c which are electrically isolated from P+ body regions 63, as shown in the corresponding schematic diagram Figures 4b and 4c. In Figure 3b, P+ body region 63b is electrically connected through overlying interconnect lead 36b, for example aluminum metallization, to body region 63. In Figure 3a or 3b, use of base-emitter junction 65 to measure the temperature within cell 60a or 60b requires only one additional cathode contact 75. Alternatively, Figure 3c cell 60c provides a second additional lead 64c to body region 63c, so that both sides of diode 65c are accessible, and test current does not have to use lead 64, which may be subject to transient effects during switching. This configuration allows a variety of electrical connections for sensing temperature.

The example as cell 60d in Figures 3d and 4d provides isolated P+ region 63d without an N+ well. P+ region 63d forms the anode of diode 61d with N-cathode region 52d. The absence of an intrinsic NPN transistor 66 mitigates the problem of reduced breakdown voltage. Cell 60d allows sensor diode 61d to be electrically referenced to drain region 52d.

Figures 5 and 6 show another example in which cell 80 diode 68, formed in polycrystalline silicon or single crystal silicon recrystallized from poly silicon, is electrically isolated by dielectric 69, for example SiO₂, from surface 53. Sensor diode 68 may be referenced to any external circuit voltage through anode lead 78 and cathode lead 79.

Sensor diodes according to the present invention are formed similarly in combination DMOS-bipolar (insulated gate bipolar) transistor (IGBT) devices which correspond to DMOS transistors with the addition of a fourth region beneath, and of opposite conductivity type from, an epitaxial layer serving as region 52, as shown for example in U.S. Patent No. 4,443,931. In an IGBT, substrate 50 comprises a second conductivity type wafer 51 for an IGBT anode, and a first conductivity type epitaxial layer 52 for the DMOS drain region.

The present invention is compatible for use with a current mirror configuration to measure current as described above with reference to Figure 2, if it is desired to measure current separately from measuring temperature.

## Claims

1. A vertical DMOS cell structure (60a) having a first conductivity type substrate drain (52), and beneath the upper surface of the substrate at least one second conductivity type body region (62), and within the body region (62) a first conductivity type source region (34), said cell structure (60a) being characterised by an operating condition sensor region (70) comprising a first region (70) of said first conductivity type in said body region (62), a first terminal (75) of said first region (70) for being connected so as to conduct a test current through or a test voltage across said first region (70) and said body region (62) while the cell is operating ordinarily.

2. The structure as claimed in claim 1, wherein the first region (70) is formed in a laterally enlarged body region (62).

## Patentansprüche

1. Senkrechte DMOS-Zellstruktur (60a) aufweisend eine Substratsenke (52) des ersten Leitfähigkeits-Typs und unter der oberen Oberfläche des Substrats zumindestens einen Körperbereich (62) des zweiten Leitfähigkeits-Typs und innerhalb des Körperbereichs (62) einen Quellenbereich (34) des ersten Leitfähligkeits-Typs, wobei besagte Zellstruktur (60a) dadurch gekennzeichnet ist, daß ein Betriebsbedingungssensorbereich (70) einen ersten Bereich (70) von besagtem Leitfähigkeits-Typ im besagten Körperbereich (62), einen ersten Anschluß (75) von besagtem ersten Bereich (70) umfaßt, um verbunden zu werden, so daß ein Teststrom durch oder eine Testspannung über besagten ersten Bereich (70) und besagten Körperbereich (62) geführt wird, während die Zelle normal arbeitet.

2. Struktur nach Anspruch 1, dadurch gekennzeichnet, daß der erste Bereich (70) in einem seitlich vergrößerten Körperbereich (62) gebildet ist.

## Revendications

1. Une structure de cellule DMOS verticale (60a) ayant un drain de substrat (52) de premier type de conductivité, et au-dessous de la surface supérieure du substrat, au moins une région de corps (62) de second type de conductivité, et à l'intérieur de la région de corps (62), une région de source (34) de premier type de conductivité, ladite structure de cellule (60a) étant caractérisée par une région de capteur d'état de fonctionnement (70) comprenant une première région (70) dudit premier type de conductivité dans ladite région du corps (62), une première borne (75) de ladite première région (70) pour être connectée de manière à conduire un courant de test ou une tension de test à travers ladite première région (70) et ladite région de corps (62) alors que la cellule fonctionne ordinairement.

2. La structure, telle que revendiquée dans la revendication 1, dans laquelle la première région (70) est formée dans une région de corps élargie latéralement (62).
